# EUROPEAN PATENT APPLICATION

(11) **EP 4 600 990 A1**
(43) Date of publication of application: **13.08.2025**
(21) Application number: 25156363.1
(22) Date of filing: 06.02.2025
(51) Int. Cl.: H01J 37/16

(54) **CHARGED PARTICLE BEAM SYSTEM**

(30) Priority: 07.02.2024 JP 2024017175
(71) Applicant: Jeol Ltd., Akishima-shi, Tokyo 196-8558 (JP)
(72) Inventor: IKEDA, Yuta, Tokyo, 196-8558 (JP); MATSUZAKI, Mizuki, Tokyo, 196-8558 (JP); YAMAZAKI, Yuji, Tokyo, 196-8558 (JP); YAMADA, Shota, Tokyo, 196-8558 (JP); OYAMA, Yoshiki, Tokyo, 196-8558 (JP)
(74) Representative: Boult Wade Tennant LLP

(57) **Abstract**

There is provided a charged particle beam system into which a sample can be easily introduced. The inventive charged particle beam system (2) comprises: a sample holder (300) for holding the sample (S); a body portion (200) equipped both with an optical system (220) for irradiating the sample (S) with a charged particle beam and with a holder support portion (230) having an insertion port (232) into/from which the sample holder (300) can be inserted and removed; and a housing (100) containing the body portion (200). The housing (100) is provided both with a recessed portion (110) and with an opening portion (120) permitting the sample holder (300) to gain access to the insertion port (232), the recessed portion (110) having a bottom (112) where the opening portion (120) is formed. The housing (100) also has a lighting device (150) for illuminating the bottom (112) of the recessed portion (110).

## Description

### BACKGROUND OF THE INVENTION

### 1. Field of the Invention

The present invention relates to a charged particle beam system and, more particularly, to a charged particle beam system which permits easy introduction of a sample into its sample chamber.

### 2. Description of the Related Art

In a charged particle beam system (such as a transmission electron microscope, a scanning transmission electron microscope, a scanning electron microscope, or a focused ion beam system), the whole or part of the body of the system may be covered by a cover to reduce noises arising from the external environment.

For example, Patent document 1 discloses a scanning electron microscope equipped with (i) a body cover enclosing vacuum pumping systems and various electric circuits, (ii) a stage cover enclosing a sample stage, and (iii) a column cover enclosing a column.

### Citation List

### Patent Documents

Patent document 1: Japanese Patent No. 6535811

In the above-described charged particle beam system, a sample is placed in a sample chamber that is maintained in a vacuum state. This system is required to allow for easy introduction of the sample into the sample chamber.

### SUMMARY OF THE INVENTION

One aspect of the charged particle beam system associated with the present invention comprises:
a sample holder for holding a sample;
a body portion equipped both with an optical system for irradiating the sample with a charged particle beam and with a holder support portion having an insertion port into/from which the sample holder can be inserted and removed; and
a housing containing the body portion.

The housing is provided both with a recessed portion and with an opening portion permitting the sample holder to gain access to the insertion port, the recessed portion having a bottom where the opening portion is formed. The housing has a lighting device for illuminating the bottom of the recessed portion.

In this charged particle beam system, the bottom of the recessed portion can be illuminated and, therefore, when the sample holder is inserted into the insertion port via the opening portion, enhanced visibility is provided. This facilitates inserting a sample into the charged particle beam system.

### BRIEF DESCRIPTION OF THE DRAWINGS

FIG. 1 is a diagram showing one example of configuration of a transmission electron microscope of the present invention.
FIG. 2 is a schematic perspective view of the transmission electron microscope of FIG. 1.
FIG. 3 is a schematic front elevation of the transmission electron microscope of FIG. 1.
FIG. 4 is a schematic cross-sectional view of main portions of the transmission electron microscope of FIG. 1.
FIG. 5 is a schematic plan view of a lighting device.
FIGS. 6 and 7 are explanatory views illustrating the operation of the lighting device of FIG. 5.
FIG. 8 is a schematic plan view of a manual controller.
FIG. 9 is a schematic cross-sectional view of the manual controller of FIG. 8.
FIG. 10 is a schematic plan view of the manual controller of FIG. 8 when in a normal mode.
FIG. 11 is a schematic plan view similar to FIG. 10 but in a maintenance mode.
FIG. 12 is a schematic view of a sample holder.
FIG. 13 is a schematic plan view of a holder support portion.
FIG. 14 is an explanatory view of an insertion port in the holder support portion of FIG. 13.
FIG. 15 is a flowchart illustrating one example of processing sequence for introducing a sample into the sample chamber of the microscope.
FIG. 16 is a schematic perspective view of a modification of the transmission electron microscope of FIG. 1.

### DESCRIPTION OF THE PREFERRED EMBODIMENTS

The preferred embodiments of the present invention are hereinafter described in detail with reference to the accompanying drawings. It is to be understood that the embodiments provided below are not intended to unduly restrict the contents of the present invention delineated by the claims and that not all the configurations set forth below are the essential constituent components of the invention.

In the following description, a charged particle beam system associated with the present invention is a transmission electron microscope that irradiates a sample with an electron beam. However, the irradiating beam may also be a charged particle beam other than an electron beam, such as an ion beam.

### 1. Transmission Electron Microscope

### 1.1. Configuration of Transmission Electron Microscope

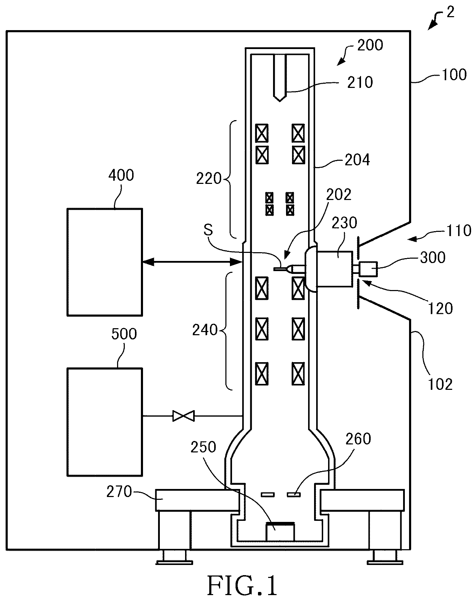

A transmission electron microscope associated with one embodiment of the present invention is first described by referring to FIG. 1, which shows one example of the configuration of this electron microscope, 2. As shown, the transmission electron microscope 2 comprises a housing 100, a body portion 200, a sample holder 300, a computerized controller 400, and a vacuum pumping system 500. The housing 100 contains the body portion 200, the controller 400, and the vacuum pumping system 500 of the transmission electron microscope 2.

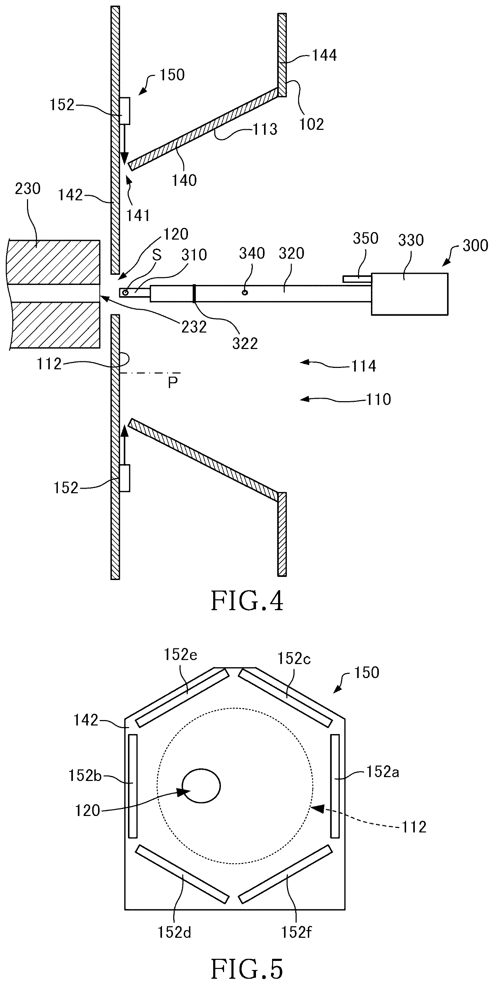

The body portion 200 comprises an electron gun 210, an illumination optical system 220 for causing electrons emitted from the electron gun 210 to be directed towards a sample S, a holder support portion 230 having an insertion port 232 (FIG. 4) into/from which the sample holder 300 can be inserted and removed, an imaging optical system 240 for focusing and imaging electrons transmitted through the sample S, an imager 250 for capturing a transmission electron microscope (TEM) image from the electrons transmitted through the sample S, and a detector 260 for detecting the electrons transmitted through the sample S and obtaining a scanning transmission electron microscope (STEM) image. The electron gun 210, the illumination optical system 220, and the imaging optical system 240 together constitute an electron optical column 204. The body portion 200 is mechanically supported by a vibration-isolated table 270. The interior of the electron optical column 204 including a sample chamber 202 is maintained in a vacuum state.

In the body portion 200, the illumination optical system 220 focuses the electron beam into an electron probe and deflects the beam. As a consequence, the sample S can be scanned with the electron probe. The transmission electron microscope 2 can derive an STEM image by detecting the electrons transmitted through the sample S by means of the detector 260 while scanning the sample S with the electron probe. Furthermore, the transmission electron microscope 2 can obtain a TEM image by directing an electron beam at the sample S in a parallel relation to the sample S through the illumination optical system 220, focusing the TEM image arising from the electrons transmitted through the sample S by means of the imaging optical system 240, and capturing the TEM image by the imager 250.

There is no restriction on the configuration of the body portion 200. For example, the body portion may also be equipped with various detectors, various spectrometers, and various manipulators. For instance, the body portion 200 may be equipped with an X-ray detector for detecting characteristic X-rays emanating from the sample S in response to irradiation of the sample S with an electron beam.

The body portion 200 has the sample chamber 202 in which the sample S is placed. The sample S in the sample chamber 202 is mechanically supported by the sample holder 300, which in turn is inserted into the insertion port of the holder support portion 230. The sample holder 300 can be inserted and withdrawn into and from the insertion port of the holder support portion 230. Accordingly, the sample holder 300 can be attached and detached to and from the holder support portion 230.

The computerized controller 400 controls various portions of the transmission electron microscope 2 and includes a processor such as a CPU (central processing unit) and storage devices such as a RAM (random access memory) and a ROM (read only memory). Programs and data for performing various control operations are stored in the storage devices. The functions of the controller 400 can be accomplished by executing programs using the processor. The controller 400 may be realized either by a general-purpose circuit (such as a microcontroller or a microprocessor) operating according to programs or by a dedicated circuit such as an ASIC (application specific integrated circuit).

The vacuum pumping system 500 pumps down the interior space of the electron optical column 204 including the sample chamber 202 and the spaces where the imager 250 and the detector 260 are disposed. The vacuum pumping system 500 is also used for pre-evacuation when the sample holder 300 is introduced into the sample chamber 202. The vacuum pumping system 500 is under control of the computerized controller 400. The computer acting as the controller 400 and the vacuum pumping system 500 may be located outside the housing 100.

### 1.2. Housing

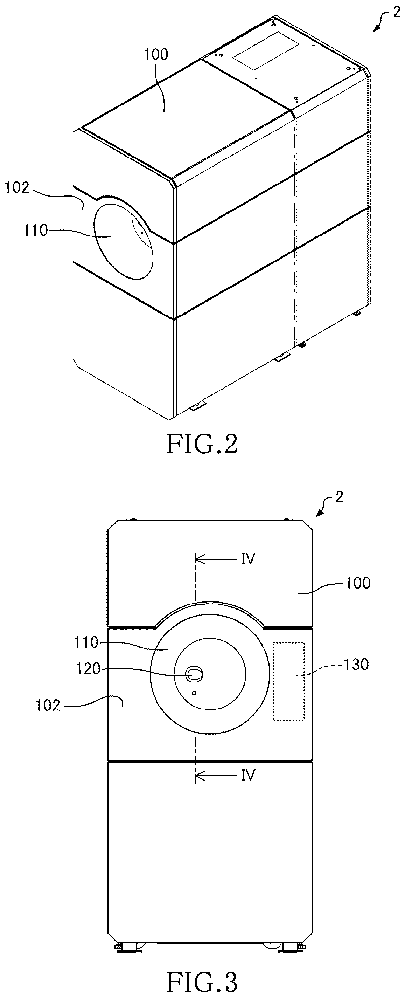

FIG. 2 is a schematic perspective view of the housing 100 which is in the form of a rectangular parallelepiped as shown. The housing 100 includes a plurality of metal plates which cover the body portion 200. Therefore, the body portion 200 cannot be viewed from the outside of the housing 100. Alternatively, the housing 100 may have a plurality of resinous plates which cover the body portion 200.

FIG. 3 is a schematic front elevation of the transmission electron microscope 2. The housing 100 is provided with a recessed portion 110 as shown in FIGS. 2 and 3. The recessed portion 110 is formed in a side surface 102 of the housing 100. The side surface 102 forms a front side surface of the housing 100. The recessed portion 110 has a bottom 112 (FIG. 4) in which an opening portion 120 is formed to permit the sample holder 300 to gain access to the insertion port 232 of the holder support portion 230.

The housing 100 also has a manual controller 130 which is responsive to manipulations by a user and mounted on the side surface 102 of the housing 100. That is, the manual controller 130 and the recessed portion 110 are on the same side surface 102. When the manual controller 130 responds to a user's manipulations, the computerized controller 400 executes a processing operation according to the user's manipulations.

FIG. 4 is a schematic cross-sectional view of main portions of the transmission electron microscope 2, as taken on line IV-IV of FIG. 3. The recessed portion 110 is in the form of a truncated cone, for example. This truncated cone increases in cross-sectional area from the bottom 112 of the recessed portion 110 toward the opening 114 of the recessed portion 110. Therefore, the opening 114 of the recessed portion 110 is greater in diameter than the bottom 112 of the recessed portion 110. As described previously, the opening portion 120 is formed in the bottom 112 of the recessed portion 110.

The housing 100 includes a first metal plate 140 (one example of a first member), a second metal plate 142 (one example of a second member), and a third metal plate 144 (one example of a third member). The first metal plate 140 is a cylindrical member having an inner surface in the form of a truncated cone shaped surface. The inner surface of the first metal plate 140 defines a side surface 113 of the recessed portion 110. The first metal plate 140 and the second metal plate 142 are in registry with each other when viewed along the direction of a vertical line P perpendicular to the bottom 112 of the recessed portion 110, i.e., in a planar view as taken from the side of the opening 114 of the recessed portion 110.

The second metal plate 142 defines the bottom 112 of the recessed portion 110. The second metal plate 142 is a flat plate or sheet, and the surface of the second metal plate 142 defines the bottom 112 of the recessed portion 110. The second metal plate 142 is provided with the opening portion 120 which extends through the second metal plate 142. The sample holder 300 can have access from the opening portion 120 to the insertion port 232 of the holder support portion 230.

A clearance 141 is formed between the first metal plate 140 and the second metal plate 142. That is, the first metal plate 140 and the second metal plate 142 are not in contact with each other. The clearance 141 surrounds the bottom 112 of the recessed portion 110. In the planar view described above, the clearance 141 is a circle surrounding the bottom 112 of the recessed portion 110.

The third metal plate 144 constitutes the side surface 102 of the housing 100. The first metal plate 140 is connected to the third metal plate 144 in which the opening 114 of the recessed portion 110 is formed. The third metal plate 144 is in the form of a flat plate and provided with a through-hole that defines the opening 114.

The housing 100 contains a lighting device 150 for illuminating the bottom 112 of the recessed portion 110. Consequently, both the opening portion 120 formed in the bottom 112 of the recessed portion 110 and the insertion port 232 of the holder support portion 230 can be illuminated.

The lighting device 150 includes a plurality of light-emitting devices 152 (152a-152f) which are arranged on the second metal plate 142 and between the first metal plate 140 and the second metal plate 142. The light-emitting devices 152 are disposed deep in the clearance 141. In the planar view, the light-emitting devices 152 are arranged behind the first metal plate 140 and thus cannot be viewed from the outside. That is, the first metal plate 140 functions as a shielding member for shielding the light-emitting devices 152 from view of the outside user.

The light-emitting devices 152 may be located between the second metal plate 142 and the third metal plate 144, and the third metal plate 144 may function as a shielding member for shielding the light-emitting devices 152 in a manner not illustrated.

Light emitted by the light-emitting devices 152 passes through the clearance 141 and falls on the bottom 112 of the recessed portion 110. Therefore, the bottom 112 of the recessed portion 110 is illuminated by the light leaking from the clearance 141. In this way, the lighting device 150 illuminates the bottom 112 of the recessed portion 110 by the light leaking from the clearance 141 by the use of the light-emitting devices 152 which are so arranged that they are invisible to the user. That is, the lighting device 150 indirectly illuminates the bottom 112 of the recessed portion 110.

The light-emitting devices 152 are light-emitting diodes (LEDs), for example. There is no restriction on the light-emitting devices 152 as long as they can emit light. They may also be laser diodes (LDs). The lighting device 150 can vary the color and intensity of its output light and is under control of the computerized controller 400.

FIG. 5 is a schematic plan view of the lighting device 150. In FIG. 5, the bottom 112 of the recessed portion 110 is indicated by a dotted line. The light-emitting devices 152 are arranged around the bottom 112 of the recessed portion 110. For example, the light-emitting devices 152 are arranged at equal intervals. In the example of FIG. 5, the light-emitting devices 152 are arranged in a hexagonal pattern around the bottom 112 of the recessed portion 110. The lighting device 150 isotropically illuminates the bottom 112 of the recessed portion 110 by means of the light-emitting devices 152 arranged around the bottom 112 of the recessed portion 110.

The light-emitting devices 152 may be arranged polygonally or circularly around the bottom 112 of the recessed portion 110 in a manner not illustrated. Also, the light-emitting devices 152 may be arranged, for example, about the center of the bottom 112 of the recessed portion 110 and in a circle having a radius greater than that of the bottom 112 of the recessed portion 110.

In the example shown in FIG. 5, the lighting device 150 includes, as the plural light-emitting devices 152, the six light-emitting devices, i.e., first light-emitting device 152a, second light-emitting device 152b, third light-emitting device 152c, fourth light-emitting device 152d, fifth light-emitting device 152e, and sixth light-emitting device 152f.

The first light-emitting device 152a and the second light-emitting device 152b are opposite to each other, between which the bottom 112 of the recessed portion 110 is located. The first light-emitting device 152a and the second light-emitting device 152b are positioned on a virtual straight line passing through the center of the bottom 112 of the recessed portion 110 in the above-described planar view. That is, the first light-emitting device 152a and the second light-emitting device 152b are arranged symmetrically with respect to the bottom 112 of the recessed portion 110.

The third light-emitting device 152c and the fourth light-emitting device 152d are arranged in a positional relationship similar to that between the first light-emitting device 152a and the second light-emitting device 152b. That is, the third light-emitting device 152c and the fourth light-emitting device 152d are opposite to each other, between which the bottom 112 of the recessed portion 110 is located. Also, the fifth light-emitting device 152e and the sixth light-emitting device 152f are arranged in a positional relationship similar to that between the first light-emitting device 152a and the second light-emitting device 152b.

The pair of the first and second light-emitting devices 152a, 152b, the pair of the third and fourth light-emitting devices 152c, 152d, and the pair of the fifth and sixth light-emitting devices 152e, 152f are spaced 60° apart from each other.

In the example of FIG. 5, the first light-emitting device 152a is thin and long in shape. However, there is no restriction on the shape. Similarly, there is no restriction on the shapes of the second through sixth light-emitting devices 152b-152f in the same manner as for the first light-emitting device 152a.

The first light-emitting device 152a has a plurality of light-emitting sections capable of producing different wavelengths (colors) of light. Therefore, the first light-emitting device 152a can emit various colors of light. Similarly, the second through sixth light-emitting devices 152b-152f can emit various colors of light.

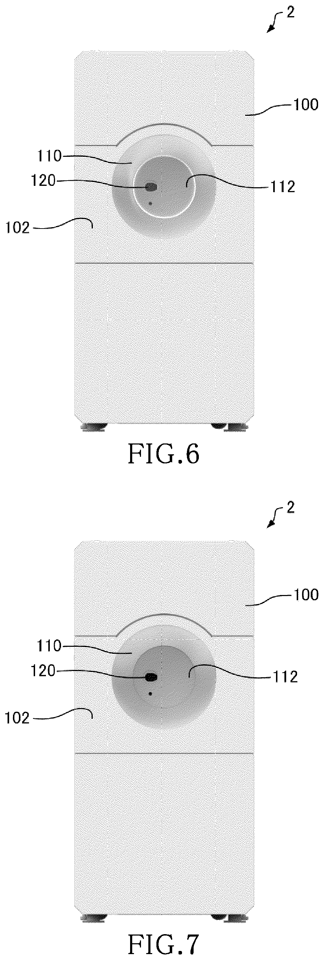

FIGS. 6 and 7 illustrate the operation of the lighting device 150. FIG. 6 illustrates an operational state in which the lighting device 150 is illuminating the bottom 112 of the recessed portion 110. FIG. 7 illustrates an operational state in which the lighting device 150 is not illuminating the bottom 112 of the recessed portion 110.

As shown in FIG. 6, the lighting device 150 illuminates the bottom 112 of the recessed portion 110 with the light leaking from the clearance 141 and so the light looks like a ring. The bottom 112 of the recessed portion 110 is illuminated with this ring-like light.

As shown in FIG. 4, the light emitted by the light-emitting devices 152 passes through the clearance 141 and impinges on the bottom 112 of the recessed portion 110 and on the side surface 113. The side surface 113 of the recessed portion 110 is a truncated cone shaped surface whose cross-sectional area increases from the bottom 112 of the recessed portion 110 toward the opening 114 of the recessed portion 110. Therefore, the intensity of the light impinging on the side surface 113 of the recessed portion 110 gradually decreases in going from the bottom 112 of the recessed portion 110 toward the opening 114 of the recessed portion 110. Consequently, gradations of brightness can be given to the contour of the ring-shaped light.

Because the recessed portion 110 is a truncated cone in shape, the light leaking from the clearance 141 assumes a ring-shaped form and thus the bottom 112 of the recessed portion 110 can be isotropically illuminated. For example, if the recessed portion 110 is a truncated pyramid, corners are formed in the recessed portion 110, thus leaving shades not illuminated. This makes it difficult to isotropically illuminate the bottom of the recessed portion 110.

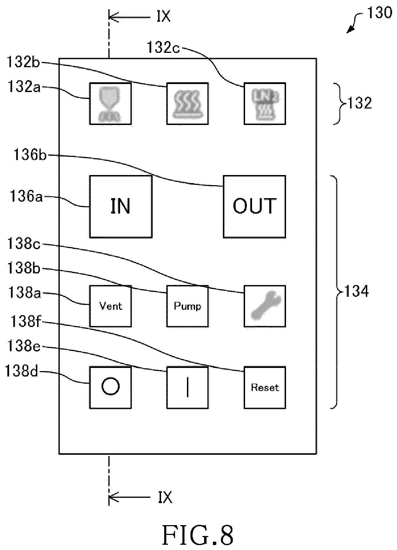

FIG. 8 is a schematic plan view of the manual controller 130. The manual controller 130 comprises a display section 132 indicating the state of the body portion 200 and a touch panel 134 responsive to manipulations by a user. The display section 132 and the touch panel 134 are mounted on the side surface 102 of the housing 100.

The display section 132 includes a first display device 132a, a second display device 132b, and a third display device 132c. The first display device 132a displays an icon representing the generation of an electron beam. The second display device 132b displays an icon indicating that the electron optical column 204 is in a baked state. The third display device 132c displays an icon indicating that a liquid nitrogen reservoir is in a baked state. Cooling liquid nitrogen used for a cold trap for maintaining the interior of the electron optical column 204 in a high vacuum is received in the liquid nitrogen reservoir. In normal usage, an icon indicating the state of the body portion 200 is displayed on the display section 132 according to the state of the body portion 200.

The display section 132 is under control of the computerized controller 400. The controller 400 controls the three display devices 132a, 132b, and 132c based on the state of the body portion 200.

The touch panel 134 includes an IN button 136a and an OUT button 136b. The IN button 136a is used to start pre-evacuation. The OUT button 136b is used to vent the pre-evacuation chamber to atmosphere.

The touch panel 134 further includes 6 buttons (138a, 138b, 138c, 138d, 138e, and 138f) for equipment maintenance. The button 138a is used to open the interior of the electron optical column 204 into the atmosphere. If the button 138a is pressed, the controller 400 opens a valve disposed between the inside and outside of the electron optical column 204, whereby the interior of the electron optical column 204 is opened to the atmosphere. The button 138b is used to pump down the interior of the electron optical column 204 to a vacuum condition. If the button 138b is pressed, the controller 400 controls the vacuum pumping system 500 such that the interior of the electron optical column 204 is evacuated to a vacuum. The button 138d is used to turn on the main power supply of the body portion 200. The button 138e is used to turn off the main power supply of the body portion 200. The button 138f is used to reset a computer functioning as the controller 400. The button 138c is used to enable the other buttons 138a, 138b, 138d, 138e, and 138f.

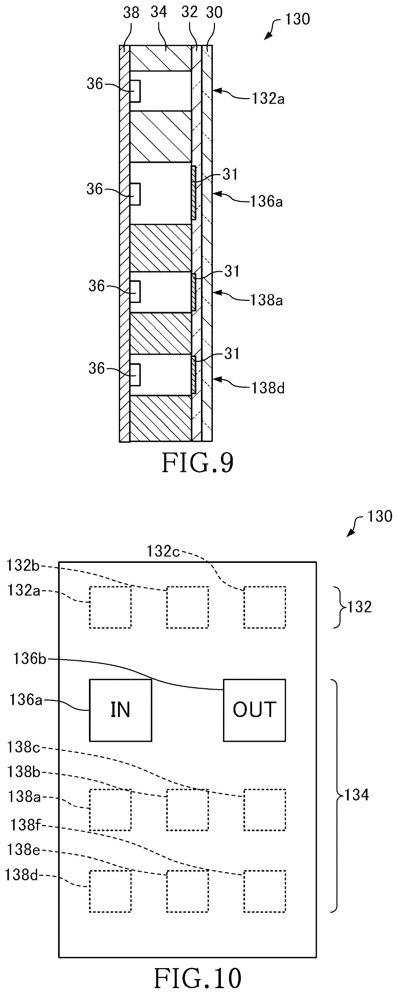

FIG. 9 is a schematic cross-sectional view of the manual controller 130. FIG. 9 is a cross-sectional view taken on line IX-IX of FIG. 8. The first display device 132a includes a transparent plate 30, an electrostatic panel 32, an optical waveguide 34, light-emitting devices 36, and a control substrate 38 as shown. The transparent plate 30 is made of an acrylic plate, for example, and printed with an icon representing generation of an electron beam. The electrostatic panel 32 is disposed on the rear side of the transparent plate 30 and is transparent, for example. The light-emitting devices 36 are disposed on the rear side of the electrostatic panel 32. Light emitted from the light-emitting devices 36 is transmitted through the optical waveguide 34 and illuminates the transparent plate 30. As the light-emitting devices 36 are lit, the icon printed on the transparent plate 30 is illuminated. This permits one to visually check the icon. On the other hand, if the light-emitting devices 36 are unlit, the user cannot check the icon visually. The light-emitting devices 36 are mounted on the control substrate 38 and under control of the computerized controller 400. The second display device 132b and the third display device 132c are configured similarly to the first display device 132a.

The IN button 136a includes the transparent plate 30, an electrostatic touch sensor 31 built in the electrostatic panel 32, the optical waveguide 34, the corresponding light-emitting device 36, and the control substrate 38. The transparent plate 30, the electrostatic panel 32, the optical waveguide 34, and the control substrate 38 are shared between the IN button 136a and the first display device 132a. The transparent plate 30 is printed with the names of the buttons. When any light-emitting device 36 is lit, the name of the button printed on the transparent plate 30 can be checked visually. The IN button 136a can be switched between ON and OFF as the touch sensor 31 responds to a touch action.

The other buttons of the touch panel 134, i.e., the OUT button 136b, buttons 138a, 138b, 138c, 138d, 138e, and 138f are configured similarly to the IN button 136a. In the foregoing description, the buttons of the touch panel 134 are of the electrostatic type. The buttons of the touch panel 134 may also be of the pressure-sensitive type.

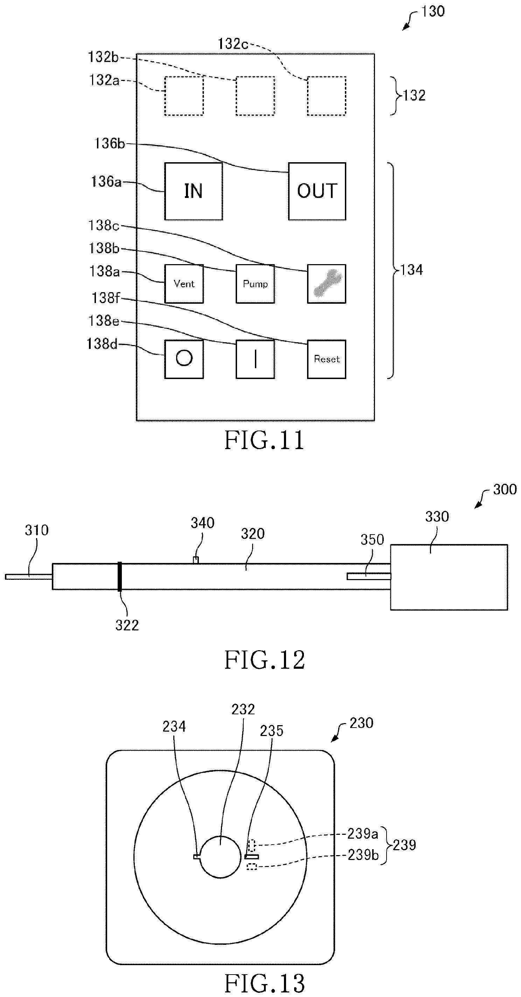

FIG. 10 is a schematic plan view of the manual controller 130 in normal mode. FIG. 11 is a plan view similar to FIG. 10 but in maintenance mode. In the normal mode illustrated in FIG. 10, the IN button 136a and the OUT button 136b can be checked visually and operations of these buttons are valid. In contrast, the buttons of the touch panel 134 other than the IN button 136a and the OUT button 136b cannot be checked visually and thus operations of these buttons are invalid. This can prevent a button to be used during maintenance from being erroneously operated during normal usage.

In the example illustrated in FIG. 10, the first through third display devices 132a, 132b, and 132c are unlit. These three display devices 132a, 132b, and 132c are turned on according to the state of the body portion 200.

When a switch is made from the normal mode illustrated in FIG. 10 to the maintenance mode illustrated in FIG. 11, any one of the unlit buttons on the touch panel 134 is first touched or plural unlit buttons are simultaneously touched. This turns on the light-emitting device 36 on the button 138c, enabling operation of the button 138. Then, the button 138c is kept touched for a given time. As a result, as shown in FIG. 11, the buttons 138a, 138b, 138d, 138e, and 138f can be checked visually, and operations of these buttons are enabled.

The method of enabling the button 138c is not restricted to the method described immediately above. For example, the touch panel 134 may have a sensor for detecting an approach of a user and, if the sensor detects the user, the light-emitting device 36 on the button 138c may be lit, and operation of the button 138c may be enabled.

### 1.3. Sample Holder and Holder Support Portion

FIG. 12 schematically shows the sample holder 300. In FIG. 12, the sample holder 300 has been rotated through 90 degrees from the sample holder 300 shown in FIG. 4. As shown in FIGS. 4 and 12, the sample holder 300 includes a sample holding portion 310, a shaft 320, a grip 330, a guide pin 340, and a shielding plate 350. The sample holding portion 310 holds the sample S and is mounted in the front end of the shaft 320. The sample holding portion 310 has a leaf spring and a sample table, for example. A sample grid to which the sample S has been secured can be fastened to the sample table by the leaf spring. There is no restriction on the method of holding the sample S on the sample holding portion 310.

An O-ring 322 is mounted on the shaft 320 to hermetically seal between the sample holder 300 and the inner surface of the insertion port 232. The grip 330 is mounted in the rear end of the shaft 320, and is the part of the sample holder 300 which is to be gripped manually.

The guide pin 340 serves to guide the sample holder 300 when the sample S held on the sample holder 300 is introduced into the sample chamber 202. The shielding plate 350 is mounted on the grip 330 and used to detect how the sample holder 300 has been inserted.

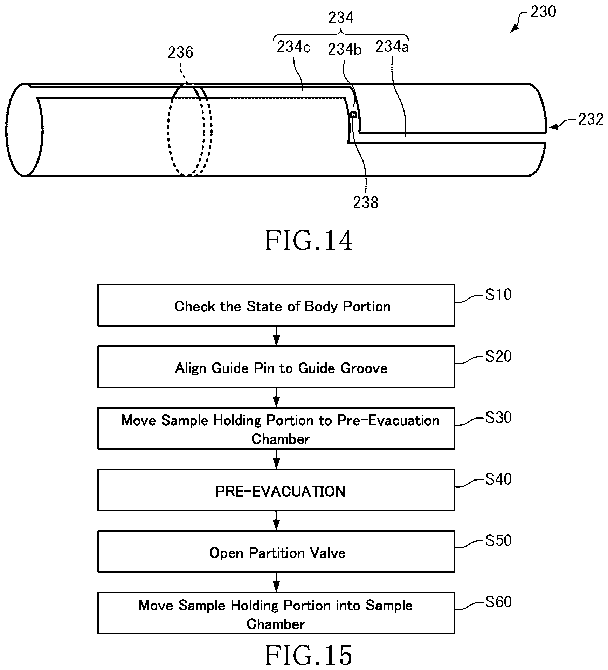

FIG. 13 is a schematic plan view of the holder support portion 230. FIG. 14 illustrates the insertion port 232 in the holder support portion 230. The insertion port 232 interconnects the outside of the body portion 200 and the sample chamber 202. The insertion port 232 has an inner wall in which a guide groove 234 is formed. The sample S held on the sample holding portion 310 can be introduced into the sample chamber 202 by moving the guide pin 340 of the sample holder 300 along the guide groove 234.

As shown in FIG. 14, the guide groove 234 has a first portion 234a, a second portion 234b, and a third portion 234c. The first groove portion 234a is formed along the central axis of the insertion port 232. The second portion 234b interconnects the first portion 234a and the third portion 234c. The second portion 234b angularly extends through 90 degrees about the central axis of the insertion port 232. The third portion 234c is formed along the central axis of the insertion port 232.

The holder support portion 230 has a partition valve 236 and a switch 238 for opening and closing the partition valve 236. The partition valve 236 is mounted in the insertion port 232. The partition valve 236 partitions the sample chamber 202 and the outside of the body portion 200 (atmospheric side) from each other. The switch 238 is mounted in the second portion 234b of the guide groove 234. The switch 238 is turned on or off as the guide pin 340 of the sample holder 300 passes through the second portion 234b of the guide groove 234.

As shown in FIG. 13, the holder support portion 230 has a sensor 239 for detecting introduction of the sample S into the sample chamber 202. A shield receiving portion 235 that is a hole for accepting the shielding plate 350 is formed near the entrance of the insertion port 232. When the sample S held on the sample holder 300 is placed in the sample chamber 202, the shielding plate 350 is inserted into the shield receiving portion 235. The sensor 239 detects that the sample S has been introduced in the sample chamber 202 in response to insertion of the shielding plate 350 into the shield receiving portion 235.

The sensor 239 includes a light-emitting device 239a such as a light-emitting diode or a laser and a photodetector 239b for detecting the light emitted by the light-emitting device 239a. When the sample S is placed in the sample chamber 202, the shielding plate 350 is inserted into the shield receiving portion 235. Consequently, the shielding plate 350 is interposed between the light-emitting device 239a and the photodetector 239b. As a result, the light emitted by the light-emitting device 239a is blocked by the shielding plate 350 and the intensity of light detected by the photodetector 239b decreases. In this way, it is possible to detect whether the sample S has been introduced in the sample chamber 202 based on a change in the intensity of light detected by the photodetector 239b.

### 2. Operation of Controller

### 2.1. Operation for Indicating the State of the Equipment

The computerized controller 400 controls the lighting device 150 based on the state of the body portion 200. In particular, the controller 400 controls at least one of the color and intensity of light, based on the state of the body portion 200. Therefore, the user can easily know the state of the body portion 200. This can reduce the possibility that the user causes the operation to proceed to thereby damage the body portion 200 in spite of an abnormality in the body portion 200.

For example, when the body portion 200 is not in operation, i.e., the vacuum pumping system 500 is not in operation and no electron beam is emitted, the controller 400 turns off the lighting device 150. When the vacuum pumping system 500 starts to operate, the controller 400 blinks the light emitted by the lighting device 150. When the interior of the electron optical column 204 reaches a given degree of vacuum, the lighting device 150 is lit in white. Therefore, with the transmission electron microscope 2, it is easy to see whether or not the body portion 200 is available for use.

When the interior of the electron optical column 204 is being vented to the atmosphere, the lighting device 150 is lit in yellow by the controller 400. Accordingly, the transmission electron microscope 2 permits the user to see easily whether the interior of the electron optical column 204 is vented to the atmosphere. If the electron optical column 204 of the body portion 200 is being baked, the controller 400 lights the lighting device 150 in orange. Therefore, the transmission electron microscope 2 permits the user to see easily whether or not the electron optical column 204 is being baked. If an error occurs in the computer functioning as the computerized controller 400, the controller 400 lights the lighting device 150 in red. Therefore, the transmission electron microscope 2 can inform the user that the body portion 200 cannot be controlled correctly.

Note that the above-described operation of the controller 400 to control the lighting device 150 based on the state of the body portion 200 is merely exemplary and that the control operation is not restricted thereto. The requirement is that the controller 400 controls at least one of the color and intensity of light based on the state of the body portion 200.

### 2.2. Operation for Indicating How Sample Holder has been Inserted

The controller 400 controls the lighting device 150 based on the manner in which the sample holder 300 has been inserted. In order to introduce the sample S into the sample chamber 202, pre-evacuation is needed. The sample holder 300 must be incrementally inserted into the insertion port 232 of the holder support portion 230.

In the transmission electron microscope 2, it is detected as to how the sample holder 300 has been inserted using the switch 238, the sensor 239, a vacuum gauge for detecting the degree of vacuum in the pre-evacuation chamber, and other components. The controller 400 controls the lighting device 150 based on the results of the detection. The controller 400 controls at least one of the color and intensity of light based on how the sample holder 300 has been inserted. Consequently, the user can know how the sample holder 300 has been inserted from variations in the color and/or intensity of the light emitted by the lighting device 150. The operations of the controller 400 are described below as well as a procedure for introducing the sample S into the sample chamber 202.

FIG. 15 is a flowchart illustrating one example of procedure for introducing the sample S into the sample chamber 202. When the sample S is introduced into the sample chamber 202, the user first makes a check as to whether the body portion 200 is ready to accept the sample S (S10). If so, the lighting device 150 is lit in white. Therefore, the user can easily know that the body portion 200 is ready to accept the sample S, i.e., the sample S can be introduced.

Then, the user carries the front end of the sample holder 300 into the insertion port 232 of the holder support portion 230 through the opening 120 formed in the bottom 112 of the recessed portion 110 and aligns the guide pin 340 to the guide groove 234 (S20). At this time, the bottom 112 of the recessed portion 110 is being illuminated by the lighting device 150 and so it is easy for the user to perform such an alignment operation.

Under this condition, the user pushes the sample holder 300 into the insertion port 232 and moves the sample holding portion 310 into the pre-evacuation chamber (S30). Pushing the sample holder 300 into the insertion port 232 moves the sample holder 300 through the insertion port 232 while the guide pin 340 is guided by the first portion 234a of the guide groove 234. When the guide pin 340 reaches the second groove portion 234b, the sample holder 300 comes to a halt. This places the sample holding portion 310 in the pre-evacuation chamber that is the space between the partition valve 236 and the O-ring 322 of the sample holder 300.

Then, the pre-evacuation chamber is pre-evacuated (S40). The pre-evacuation is started when the user pushes the IN button 136a. During the pre-evacuation, the pre-evacuation chamber is evacuated to a vacuum by the vacuum pumping system 500. The controller 400 operates the vacuum pumping system 500 according to operational information from the IN button 136a, whereby the pre-evacuation is initiated.

Upon initiation of pre-evacuation, the controller 40 blinks the lighting device 150 in blue. If the IN button 136a is pressed, the controller 400 determines that pre-evacuation is started, and blinks the lighting device 150 in blue. If the pressure in the pre-evacuation chamber decreases below a given pressure, the controller 400 lights the lighting device 150 in blue. The controller 400 determines that the pressure in the pre-evacuation chamber is below the given pressure, for example, from the results of a measurement performed by a pressure gauge (vacuum gauge) for measuring the pressure (degree of vacuum) in the pre-evacuation chamber.

In this way, if the pre-evacuation is completed, the lighting device 150 makes a switch from a blue blinking state to a blue lit state. Accordingly, the user can easily know that the pre-evacuation is completed.

Then, the partition valve 236 is opened (S50). The user rotates the sample holder 300 about the shaft 320 through 90 degrees. Thus, the guide pin 340 is guided by the second portion 234b of the guide groove 234 and reaches the third portion 234c. At this time, the guide pin 340 strikes the switch 238, turning it on. This causes the controller 400 to open the partition valve 236.

Then, the user pushes the sample holder 300 in and moves the sample holding portion 310 into the sample chamber 202 (S60) while the guide pin 340 is in the third groove portion 234c. Consequently, the guide pin 340 is guided by the third groove portion 234c and the sample holder 300 moves through the insertion port 232. As a result, the sample holding portion 310 moves into the sample chamber 202. Because of the processing steps described thus far, the sample S held on the sample holding portion 310 can be introduced into the sample chamber 202.

When the sample S is placed in the sample chamber 202, the shielding plate 350 of the sample holder 300 is interposed between the light-emitting device 239a and the photodetector 239b. Thus, the sensor 239 detects that the sample S has been introduced in the sample chamber 202. If the sensor 239 detects that the sample S has been introduced in the sample chamber 202, the controller 400 blinks the lighting device 150 in blue several times and then lights the lighting device 150 in blue and so the user can grasp that the sample S has been placed in the sample chamber 202.

In the foregoing description, the controller 400 blinks or lights the lighting device 150 based on the manner in which the sample holder 300 has been inserted. Alternatively, the controller 400 may vary at least one of the color and intensity of light emitted by the lighting device 150 based on the manner in which the sample holder 300 has been inserted. Varying the intensity of light emitted by the lighting device 150 involves varying the brightness of the light, making a switch among blinking, lighting, and turning off, varying the blinking interval, varying the number of blinks, and varying the blinking pattern.

Furthermore, in the foregoing description, the manner in which the sample holder 300 has been inserted is detected by the switch 238, the sensor 239, and the pressure gauge (vacuum gauge) that measures the pressure in the pre-evacuation chamber. The means of detecting the manner in which the sample holder 300 has been inserted is not restricted to these means.

### 2.3. Energy-Saving Mode

If no operation is performed on the touch panel 134 for a preset time, the controller 400 reduces the intensity of light emitted by the lighting device 150, for example, to 50%. If there is a touch on the touch panel 134 while the intensity of the light has been reduced, the controller 400 returns the intensity of the light emitted by the lighting device 150 to its original intensity.

### 3. Advantageous Effects

The transmission electron microscope 2 comprises the sample holder 300, the body portion 200, and the housing 100 that houses the body portion 200. The body portion 200 has the holder support portion 230 equipped with the insertion port 232 into/from which the sample holder 300 can be inserted and removed. The housing 100 has the recessed portion 110 and the opening portion 120 formed in the bottom of the recessed portion 110. The opening portion 120 permits the sample holder 300 to gain access to the insertion port 232. Furthermore, the housing 100 has the lighting device 150 for illuminating the bottom 112 of the recessed portion 110. Therefore, in the transmission electron microscope 2, the bottom 112 of the recessed portion 110 can be illuminated and, therefore, enhanced visibility can be provided when the sample holder 300 is inserted into the insertion port 232 through the opening portion 120. Consequently, the transmission electron microscope 2 facilitates introducing the sample S into the sample chamber 202.

As shown in FIG. 1, in the body portion 200, the electron optical column 204 including the sample chamber 202 is narrower than the vibration-isolated table 270 and other components. Therefore, in the transmission electron microscope 2, the provision of the recessed portion 110 in the housing 100 in the form of a rectangular parallelepiped allows insertion of the sample holder 300 into the insertion port 232. However, lighting equipment in the room where the transmission electron microscope 2 is installed may not illuminate the bottom of the recessed portion 110. In the transmission electron microscope 2, the housing 100 has the lighting device 150 and so the bottom 112 of the recessed portion 110 can be illuminated. Hence, enhanced visibility is provided.

In the transmission electron microscope 2, the recessed portion 110 is shaped in the form of a truncated cone and increases in cross-sectional area from the bottom 112 of the recessed portion 110 toward the opening 114 of the recessed portion 110. Therefore, in the transmission electron microscope 2, the bottom 112 of the recessed portion 110 can be easily checked visually from any direction. Accordingly, in the transmission electron microscope 2, the insertion port 232 can be easily checked visually irrespective of the boy height of the user, the user's dominant hand, or the user's posture. For example, when the user inserts the sample holder 300 while seating or standing, the insertion port 232 is not shadowed by the housing 100 but rather can be easily checked visually.

In the transmission electron microscope 2, the housing 100 includes the first metal plate 140 defining the side surface 113 of the recessed portion 110 and the second metal plate 142 defining the bottom 112 of the recessed portion 110, the second metal plate 142 being provided with the opening portion 120. The clearance 141 is formed between the first metal plate 140 and the second metal plate 142. The bottom 112 of the recessed portion 110 is illuminated by light leaking from the clearance 141. Therefore, in the transmission electron microscope 2, the bottom 112 of the recessed portion 110 can be indirectly illuminated. For example, where light emitted by the plural light-emitting devices 152 is made to directly strike the bottom 112 of the recessed portion 110, the light directly enters the user's eyes depending on the posture of the user or the position at which the user stands, thus dazzling the eyes. In the transmission electron microscope 2, the bottom 112 of the recessed portion 110 is illuminated by light leaking from the clearance 141 and so the light can be prevented from directly entering the user's eyes.

In the transmission electron microscope 2, the lighting device 150 includes the plural light-emitting devices 152. The light emitted by the light-emitting devices 152 passes through the clearance 141 and falls on the bottom 112 of the recessed portion 110. Therefore, in the transmission electron microscope 2, the bottom 112 of the recessed portion 110 can be indirectly illuminated.

In the transmission electron microscope 2, the plural light-emitting devices 152 are arranged around the bottom 112 of the recessed portion 110 and, therefore, in the microscope 2, the bottom 112 of the recessed portion 110 can be isotropically illuminated.

The transmission electron microscope 2 includes the first light-emitting device 152a and the second light-emitting device 152b between which the bottom 112 of the recessed portion 110 is located. Therefore, in the transmission electron microscope 2, the bottom 112 of the recessed portion 110 can be more isotropically illuminated than where the bottom 112 of the recessed portion 110 is illuminated with only one light-emitting device.

In the transmission electron microscope 2, the housing 100 includes the first metal plate 140 serving as a shielding member for shielding the plural light-emitting devices 152. Therefore, in the transmission electron microscope 2, light can be prevented from directly entering the user's eyes and thus the bottom 112 of the recessed portion 110 can be checked visually with greater ease.

The transmission electron microscope 2 includes the computerized controller 400 which controls the lighting device 150 based on the manner in which the sample holder 300 has been inserted. Therefore, when the sample S is introduced into the sample chamber 202 of the transmission electron microscope 2, the manner in which the sample holder 300 has been inserted can be grasped without looking away from the sample holder 300. Accordingly, in the transmission electron microscope 2, if the user looks away from the sample holder 300, the sample holder 300 would contact the housing 100 and other parts, thus damaging the sample S and the sample holder 300.

In the transmission electron microscope 2, at least one of the color and intensity of light emitted by the lighting device 150 is controlled based on the manner in which the sample holder 300 has been inserted. Therefore, the transmission electron microscope 2 permits one to grasp the manner in which the sample holder 300 has been inserted without looking away from the sample holder 300 when the sample S is introduced into the sample chamber 202.

In the transmission electron microscope 2, when pre-evacuation in preparation for introduction of the sample S into the sample chamber 202 is completed, at least one of the color and intensity of the light emitted by the lighting device 150 is varied. Therefore, the transmission electron microscope 2 permits one to grasp the completion of the pre-evacuation without looking away from the sample holder 300 when the sample S is introduced into the sample chamber 202.

The transmission electron microscope 2 includes the computerized controller 400 for controlling the lighting device 150 based on the state of the body portion 200. Therefore, the transmission electron microscope 2 permits one to grasp the state of the body portion 200 easily. Furthermore, the transmission electron microscope 2 allows one to grasp the state of the body portion 200 without looking away from the sample holder 300 when the sample S is introduced into the sample chamber 202.

In the transmission electron microscope 2, the housing 100 includes the touch panel 134 responsive to manipulations by a user. The touch panel 134 is disposed on the side surface 102 in which the recessed portion 110 of the housing 100 is formed. Therefore, in the transmission electron microscope 2, the recessed portion 110 and the touch panel 134 are disposed on the same side surface of the housing 100. This facilitates manipulating the touch panel 134 when the sample S is introduced into the sample chamber 202.

### 4. Modifications

### 4.1. First Modification

In the above embodiment, the computerized controller 400 controls the lighting device 150, the body portion 200, and the vacuum pumping system 500. Alternatively, the transmission electron microscope 2 may have a computer serving as a first controller for controlling the body portion 200 and the vacuum pumping system 500 and another computer serving as a second controller for controlling the lighting device 150. In this alternative instrument, information about the manner in which the sample holder 300 has been inserted and information about the state of the body portion 200 may be sent from the first controller controlling the body portion 200 to the second controller controlling the lighting device 150.

### 4.2. Second Modification

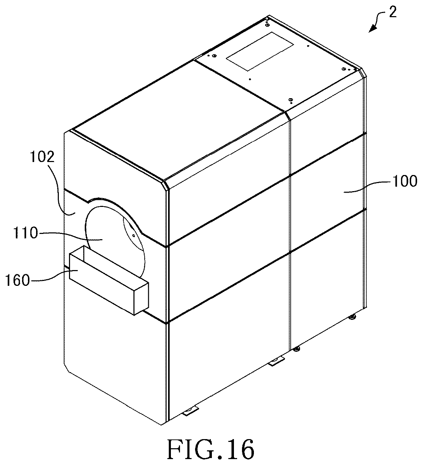

FIG. 16 is a schematic perspective view of a modification of the transmission electron microscope 2. This modified microscope, also indicated by reference numeral 2 in FIG. 16, has a liquid reservoir 160. The liquid reservoir 160 is detachably attached to the housing 100, for example, magnetically. If the sample holder 300 is for use in a cryo-electron microscope equipped with a tank for holding a coolant such as liquid nitrogen or liquid helium, when the sample S is introduced into the sample chamber 202, the coolant may spill from the sample holder 300, whereby the coolant is poured over the user. In the transmission electron microscope 2, the coolant spilling from the sample holder 300 can be caught in the liquid reservoir 160. This can protect the user against the spilling coolant. Furthermore, the coolant spilling from the tank of the sample holder 300 can be recovered.

### 4.3. Third Modification

In the above-described modification illustrated in FIG. 5, the lighting device 150 illuminates the bottom 112 of the recessed portion 110 by the use of the plural light-emitting devices 152 arranged around the bottom 112 of the recessed portion 110. The configuration of the lighting device 150 is not restricted to this. For example, the lighting device 150 may illuminate the bottom 112 of the recessed portion 110 with a combination of one light-emitting device and plural mirrors which reflect light emitted by the light-emitting device. Furthermore, the lighting device 150 may illuminate the bottom 112 of the recessed portion 110 with a combination of plural light-emitting devices and plural mirrors. In addition, the lighting device 150 may be equipped with light-emitting devices and optical waveguides such as optical fibers. In this case, the bottom 112 of the recessed portion 110 may be illuminated by conveying light, which is emitted by the light-emitting devices remote from the bottom 112 of the recessed portion 110, to the bottom through the optical waveguides.

### 4.4 Fourth Modification

In the foregoing embodiment, the charged particle beam system associated with the present invention is a transmission electron microscope. The charged particle beam system associated with the present invention is also applicable to other charged particle beam system equipped with an optical system for irradiating a sample with a charged particle beam such as an electron beam or an ion beam. For example, the charged particle beam system associated with the present invention may be a scanning electron microscope, an Auger electron spectrometer, or an electron probe microanalyzer. In addition, the charged particle beam system associated with the present invention may be a focused ion beam (FIB) system for directing an ion beam at a sample.

Note that the foregoing embodiments and modifications are merely exemplary and that the present invention is not restricted thereto. For example, the embodiments and modifications may be appropriately combined.

It is to be understood that the present invention is not restricted to the foregoing embodiments and that the invention may be practiced in variously modified forms. For example, the present invention embraces configurations (e.g., configurations identical in function and method) which are substantially identical to the configurations described in any one of the above embodiments. Furthermore, the invention embraces configurations which are similar to the configurations described in any one of the above embodiments except that their nonessential portions have been replaced. Further, the invention embraces configurations which are similar to the configurations described in any one of the above embodiments except that a well-known technique is added.

## Claims

1. A charged particle beam system comprising;
a sample holder for holding a sample;
a body portion equipped both with an optical system for irradiating the sample with a charged particle beam and with a holder support portion having an insertion port into/from which the sample holder can be inserted and removed; and
a housing containing the body portion;
wherein the housing is provided both with a recessed portion and with an opening portion permitting the sample holder to gain access to the insertion port, the recessed portion having a bottom where the opening portion is formed; and
wherein the housing has a lighting device for illuminating the bottom of the recessed portion.

2. A charged particle beam system as set forth in claim 1, wherein said recessed portion is shaped in the form of a truncated cone which increases in cross-sectional area from the bottom of the recessed portion toward the opening portion of the recessed portion.

3. A charged particle beam system as set forth in any one of claims 1 and 2,
wherein said housing includes both a first member defining a side surface of said recessed portion and a second member defining the bottom of the recessed portion and provided with said opening portion, a clearance being formed between the first member and the second member; and
wherein the bottom of the recessed portion is illuminated with light leaking from the clearance.

4. A charged particle beam system as set forth in claim 3, wherein said lighting device includes a plurality of light-emitting devices whose output light is made to impinge on the bottom of said recessed portion through said clearance.

5. A charged particle beam system as set forth in any one of claims 1 and 2, wherein said lighting device includes a plurality of light-emitting devices which are arranged around the bottom of said recessed portion.

6. A charged particle beam system as set forth in any one of claims 1 and 2, wherein said lighting device includes a first light-emitting device and a second light-emitting device between which the bottom of said recessed portion is located.

7. A charged particle beam system as set forth in any one of claims 1 and 2, wherein said lighting device includes a plurality of light-emitting devices, and wherein said housing includes a shielding member that shields the plurality of light-emitting devices.

8. A charged particle beam system as set forth in any one of claims 1 to 7, further comprising a controller for controlling said lighting device based on the manner in which said sample holder has been inserted.

9. A charged particle beam system as set forth in claim 8, wherein said controller controls at least one of color and intensity of light emitted by said lighting device based on the manner in which said sample holder has been inserted.

10. A charged particle beam system as set forth in claim 9, wherein when pre-evacuation in preparation for introduction of said sample into the sample chamber is completed, said controller varies at least one of the color and intensity of the light emitted by said lighting device.

11. A charged particle beam system as set forth in any one of claims 1 to 10, further comprising a controller for controlling said lighting device based on the state of said body portion.

12. A charged particle beam system as set forth in any one of claims 1 to 11, wherein said housing includes a touch panel responsive to manipulations by a user, and wherein the touch panel is mounted on a side surface of the housing where said recessed portion is formed.
